# EUROPÄISCHE PATENTSCHRIFT

(11) **EP 1 139 091 B1**
(45) Veröffentlichungstag und Bekanntmachung des Hinweises auf die Patenterteilung: **19.08.2009**
(21) Anmeldenummer: 00106546.5
(22) Anmeldetag: 27.03.2000
(51) Int. Cl.: G01N 23/225, H01J 37/28, H01J 37/26

(54) **Elektronenspektrometer mit Ablenkeinheit**
Electron spectrometer with deflection unit
Spectromètre élétronique avec unité de déflection

(43) Veröffentlichungstag der Anmeldung: 04.10.2001
(73) Patentinhaber: ELLCIE Maintenance GmbH, 23936 Grevesmühlen (DE)
(72) Erfinder: Marienhoff, Peter, Dr., 23936 Grevesmühlen (DE)
(74) Vertreter: Hemmer, Arnd

(56) Entgegenhaltungen:
- US-A- 4 658 137
- US-A- 4 812 651
- US-A- 4 845 361

## Beschreibung

Die Erfindung betrifft ein Sekundärelektronen-Spektrometer mit Ablenkeinheit für flächige Proben. Die erfindungsgemäße Ausführung weist in einer ersten Richtung x einen sehr großen sensitiven Bereich a auf. In der zur besagten Richtung x senkrechten Richtung y in der Probenebene werden Sekundärelektronen nur aus einem sehr viel kleineren Bereich b nachgewiesen. Das Verhältnis a/b kann z.B. 30 betragen und ist in jedem Fall größer x. Das System wird zwischen eine Elektronenkanone und die Probe gesetzt. Ein schlitzförmiger Bereich a'b ist frei von Elektroden, insbesondere auch von Netzen und ergibt einen ungehinderten Bewegungsraum für die Primär- und Sekundärelektronen.

Elektroden entlang der ersten Richtung x erzeugen Absaug- und Gegenfelder. Eine Spule in x-Richtung erzeugt ein Magnetfeld, das zur Fokussierung des Primärstrahls und zur Führung der Sekundärelektronen beiträgt. Oberhalb des eigentlichen Spektrometers ist eine speziell für dieses System abgestimmte Ablenkeinheit angeordnet bestehend aus mehreren Ablenkplatten sowie einem Paar Helmholtzspulen. Alle Ablenkfelder werden im gleichen Raumgebiet dicht unter der Elektronenkanone erzeugt. Das Detektorsystem zeichnet sich durch eine gute Meßgenauigkeit (Potentialauflösungsvermögen, Spektrometerkennlinie) weitgehend unabhängig vom Meßort innerhalb der sehr breiten sensitiven Zone aus.

Die Erfindung betrifft eine Anordnung zum Führen von Primärelektronen zu einer flächigen Probe sowie zum Nachweis und zur Energiebestimmung der Sekundärelektronen (Spannungskontrast-Detektorsystem) entsprechend des Oberbegriffs des Patentanspruchs 1.

Die Erfindung fällt in das Gebiet des kontaktlosen Testens von Verdrahtungsnetzwerken wie z.B. gedruckten Platinen oder Flach-Bildschirmen mit Hilfe des Elektronenstrahls. Die wahrscheinlichste (häufigste) Energie der Sekundärelektronen kann mit diesem System gemessen werden und ergibt das momentane elektrische Potential des bestrahlten Meßflecks. Gleichzeitig kann der Vorgang des Bestrahlens zu einem Laden des Netzwerkes führen, d.h. einer Änderung des Potentials entsprechend dem vom Primärstrahl ausgelösten Netto-Ladestrom und der Kapazität.

Der Erfindung liegt die Aufgabe zugrunde, insbesondere eine Anordnung zum schnellen Testen von großflächigen Leiterplatten anzugeben. Eine Leiterplatte enthält eine Vielzahl von Netzwerken aus Kontaktpunkten, die mit Leiterbahnen verbunden sind. Ein Leiterplattentest muß eine Verbindung zwischen zwei beliebigen Netzen (Kurzschluß) sowie einen von seinem Netz getrennten Kontaktpunkt (Unterbrechung) finden. Alle benötigten Potentialmessungen/- änderungen finden idealerweise statt, während die Platine relativ zum Detektor kontinuierlich in y-Richtung bewegt wird.

Eine Grundform für ein Spektrometer zum Einbau zwischen Probe und eletronenoptischer Säule eines Rasterelektronenmikroskops wurde z.B. beschrieben von H.P. Feuerbaum, Scanning Elektron Microscopy 1979, 1, S. 285-290. Bisher beschriebene Elektronenspektrometer zur Spannungs-messung sind entweder nur für recht kleine Bereiche auf der Probe geeignet, wie z.B. aus
EP-Patent 0 402 499 von 12/90, M. Brunner, Siemens AG
US-Patent 4 728 790 von 08/88 von E. Plies, Siemens AG
EP-Patent 0 138 610 von 04/86, S. Garth, Texas Instruments, Inc.
   bekannt, oder mit Drahtnetzen aufgebaut, siehe etwa
US-Patent 4 812 651 von 03/89, H.P. Feuerbaum, J. Frosien, Siemens AG
US-Patent 5 602 489 von 02/97, A. el-Kareh, Alcedo
US-Patent 4 829 243 von 05/89, O. Woodard, Microelectronics and Computer Tech. Corp.
US-Patent 5 606 261 von 02/97, S. Golladay, IBM Corporation
US-Patent 4 169 244 von 09/79, G. Plows, Cambride.

Im ersten Fall sind die großen Flächen nur durch zweidimensionales mechanisches Rastern und damit sehr langsam zu erfassen, im zweiten Fall sind die Drahtnetze zugleich auch Hindernisse für den Primärstrahl und können zu schwer erkennbaren Meßartefakten und erhöhtem Signaluntergrund führen.

In der US-PS 4 845 361 ist im Detail offenbart, wie generell optimale Spektrometereigenschaften erreicht werden können. Diese Druckschrift beschäftigt sich jedoch nicht mit dem Problem, wie wechselnde Meßbereiche auf einer flächigen Probe ausgewählt werden können.

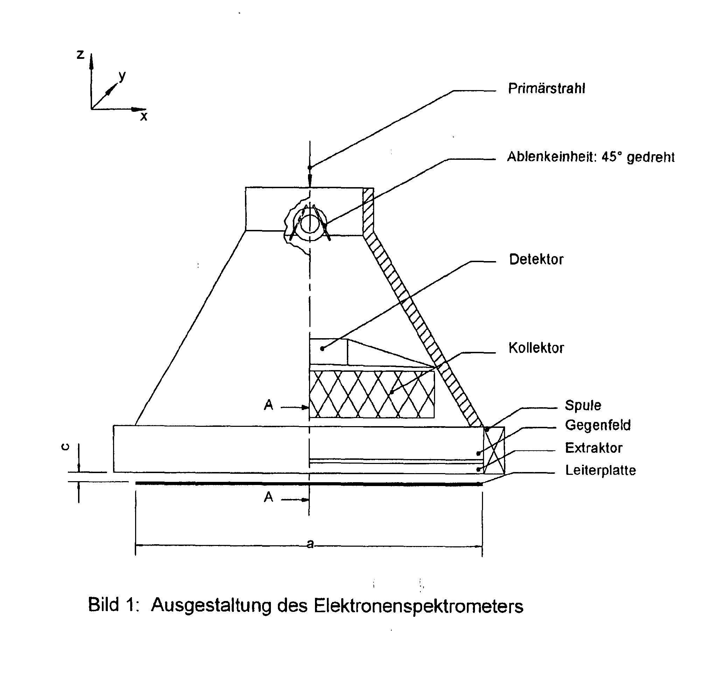

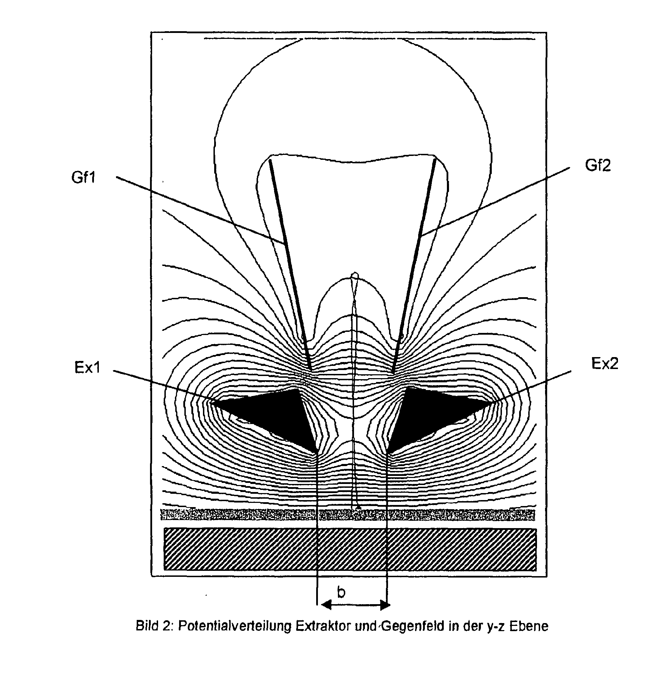

Die genannten Nachteile der bisherigen Ausführungen werden durch die erfindungsgemäße Ausgestaltung nach Anspruch 1 überwunden. Die weiteren Ansprüche beziehen sich auf bevorzugte Ausgestaltungen, die im folgenden anhand der Bilder 1 und 2 beschrieben werden.

Bild 1 zeigt schematisch ein Ausführungsbeispiel des besagten Spannungskonstrast-Detektorsystems. Es wurde unter die Endlinse einer üblichen zylindersymmetrischen Elektronensäule (mit Kondensator, Fokussierung, Stigmator und schneller Strahlaustastung) montiert und kann eine

Leiterplatte in ihrer vollen Breite von z.B. a = 300 mm erfassen. In y-Richtung ist nur ein Bereich von z.B. b = 10 mm vom Detektorsystem erfaßt.

Bild 2 zeigt einen Schnitt AA in der yz-Ebene. Dargestellt ist eine geeignete Elektrodenanordnung und Spannungsbelegung mit den elektrischen Potentiallinien sowie eine Trajektorie eines Sekundärelektrons mit zu geringer Energie, um durch das Gegenfeld zu gelangen.

Das Spektrometer weist eine Reihe von Elektroden entlang der ersten Richtung x auf. Die Anordnung der Elektroden beidseitig der Schmalseite b ist vorzugsweise symmetrisch, die Potentiale jedoch nicht notwendigerweise gleich. Das Elektrodenpaar Ex1, Ex2 nahe der Probe wird mit hohem positiven Potential versorgt und dient als Extraktor für die Sekundärelektronen. Nützlich kann ein weiteres Elektrodenpaar dicht unter dem Extraktor auf nahezu Massepotential sein zur Linearisierung des Feldes und zur Angleichung des Signales von außermittigen Meßpunkten. Darüber liegen Elektroden Gf1, Gf2 mit zumeist leicht negativem Potential als Energiefilter (Gegenfeldspektrometer). Nur Sekundärelektronen ab einer gewissen Energie können nach oben passieren. Zur Unterstützung der Filterwirkung kann eine senkrecht stehende Spule eingesetzt werden, die ein im wesentlichen zur Platine senkrechtes homogenes Magnetfeld erzeugt. Oberhalb des Filters ist eine Seite als Kollektor mit positiver Spannung ausgeführt und leitet alle Sekundärelektronen in einen SE-Vervielfacher (z.B. Channeltron) oder auf einen Leuchtschirm mit Photomultiplier.

Darüber sitzt die Ablenkvorrichtung für den Primärstrahl. Zur Ablenkung in x-Richtung kommen 2 Platten und ein Helmholtz-Spulenpaar senkrecht zu den Platten zum Einsatz. Sie verbiegen die Elektronenbahn so, daß der gewünschte Punkt innerhalb des Schlitzes bestrahlt wird. Gute Strahlqualität bleibt in einem Ablenkwinkelbereich von 70° erhalten. Für noch größere Ablenkwinkel und eine damit verkürzte Bauform des Systems lassen sich anstelle der Helmholtzspulen offensichtlich auch komplexe Sattelspulen einsetzen. Bei Verwendung der Spule senkrecht zur Platine wird der Ablenkgenerator etwa 45° verdreht zum Schlitz aufgebaut, da die Spule zugleich eine Bilddrehung bewirkt. Der Vorteil bei Verwendung der besagten Spule liegt auch darin, daß der Primärstrahl dann nahezu senkrecht auf die Platine auftrifft. Zur Ablenkung in y-Richtung genügt ein einfaches paralleles Plattenpaar in den Helmholtzspulen. Alternativ kann auch ein in der elektronenoptischen Säule bereits vorhandenes Ablenksystem verwendet werden.

## Patentansprüche

1. Elektronenspektrometer mit Ablenkeinheit für flächige Proben, **dadurch gekennzeichnet, daß** der sensitive Bereich des Spektrometers in der Probenebene, in dem Sekundärelektronen nachgewiesen werden, in einer ersten Richtung sehr viel größer als in der zur besagten ersten Richtung senkrechten Richtung ist, sodaß ein schlitzförmiger Bereich gebildet wird, der frei von Netzen ist und einen ungehinderten Bewegungsraum für die Primär- und Sekundärelektronen ergibt, daß durch die Ablenkeinheit der Primärstrahl in beide Richtungen und somit zu jedem Punkt im sensitiven Bereich des Spektrometers gelenkt werden kann und daß eine Reihe von Elektroden, die als Extraktor für die Sekundärelektronen dienen, entlang der besagten ersten Richtung beidseitig der Schmalseite des schlitzförmigen Bereiches angeordnet ist.

2. Elektronenspektrometer nach Anspruch 1, **dadurch gekennzeichnet, daß** ein der Probe benachbartes Elektrodenpaar auf hohes positives Potential gelegt ist, um die Sekundärelektronen von der Probe zum Spektrometer zu beschleunigen.

3. Elektronenspektrometer nach den Ansprüchen 1 und 2, **dadurch gekennzeichnet, daß** ein weiteres Elektrodenpaar auf leicht negatives regelbares Potential gelegt ist und nur Sekundärelektronen zur Detektion kommen läßt, die eine gewisse Energie überschreiten.

4. Elektronenspektrometer nach den Ansprüchen 1 bis 3, **dadurch gekennzeichnet, daß** eine Kollektorelektrode und weitere Ablenkplatten die Sekundärelektronen, aber keine reflektierten Elektronen, zum Detektor leiten.

5. Elektronenspektrometer nach den Ansprüchen 1 bis 4, **dadurch gekennzeichnet, daß** eine Spule senkrecht auf der Probe um das Spektrometer aufgebaut ist.

## Claims

1. An electron spectrometer with a deflection unit for flat samples, **characterised in that** the sensitive region of the spectrometer in the sample plane, in which secondary electrons are detected, is very much larger in a first direction than in the direction which is perpendicular to the said first direction, so that a slot-like region is formed, which is free of nets, and results in an uninhibited movement space for the primary electrons and secondary electrons, that by way of the deflection unit, the primary beam may be guided in both directions and thus to every point in the sensitive region of the spectrometer and that a series of electrodes which serve as extractors for the secondary electrons, is arranged along the said first direction on both sides of the narrow side of the slot-like region.

2. An electron spectrometer according to claim 1, **characterised in that** an electrode pair adjacent the sample is applied to a high positive potential, in order to accelerate the secondary electrons from the sample to the spectrometer.

3. An electron spectrometer according to the claims 1 and 2, **characterised in that** a further electrode pair is applied to a slightly negative potential, which may be controlled with a closed loop, and only secondary electrons which exceed a certain energy, may come to be detected.

4. An electron spectrometer according to the claims 1 to 3, **characterised in that** a collector electrode and further deflection plates lead the secondary electrons, but not reflected electrons, to the detector.

5. An electron spectrometer according to the claims 1 to 4, **characterised in that** a coil is constructed perpendicularly on the sample around the spectrometer.

## Revendications

1. Spectromètre électronique avec unité de déflexion pour échantillons plats, **caractérisé en ce que** la zone sensible du spectromètre dans le plan de l'échantillon, dans laquelle sont mis en évidence des électrons secondaires, est beaucoup plus large dans une première direction que dans la direction perpendiculaire à ladite première direction, de façon à former une zone en forme de fente qui est exempte de réseaux et constitue pour les électrons primaires et secondaires un espace de circulation sans entrave, **en ce que**, par le biais de l'unité de déflexion, le faisceau primaire peut être dirigé dans les deux directions et, par conséquent, en chaque point de la zone sensible du spectromètre, et **en ce qu'**une série d'électrodes, servant d'extracteur aux électrons secondaires, est disposée le long de ladite première direction de part et d'autre du petit côté de la zone en forme de fente.

2. Spectromètre électronique selon la revendication 1, **caractérisé en ce qu'**une paire d'électrodes adjacente à l'échantillon est mise à un potentiel positif élevé pour accélérer les électrons secondaires de l'échantillon vers le spectromètre.

3. Spectromètre électronique selon les revendications 1 et 2, **caractérisé en ce qu'**une autre paire d'électrodes est mise à un potentiel réglable légèrement négatif et ne permet de détecter que des électrons secondaires qui dépassent une certaine énergie.

4. Spectromètre électronique selon les revendications 1 à 3, **caractérisé en ce qu'**une électrode collecteur et d'autres plaques de déflexion acheminent au détecteur les électrons secondaires, mais pas d'électrons réfléchis.

5. Spectromètre électronique selon les revendications 1 à 4, **caractérisé en ce qu'**une bobine est montée verticalement sur l'échantillon autour du spectromètre.
